# EUROPÄISCHE PATENTSCHRIFT

(11) **EP 0 883 825 B1**
(45) Veröffentlichungstag und Bekanntmachung des Hinweises auf die Patenterteilung: **11.12.2002**
(21) Anmeldenummer: 97905138.0
(22) Anmeldetag: 28.02.1997
(51) Int. Cl.: G02B 6/12

(54) **VERFAHREN ZUR HERSTELLUNG OPTISCHER BAUELEMENTE MIT ANGEKOPPELTEN LICHTWELLENLEITERN UND NACH DIESEM VERFAHREN HERGESTELLTE OPTISCHE BAUELEMENTE**
PROCESS FOR THE PRODUCTION OF OPTICAL COMPONENTS WITH COUPLED OPTICAL WAVEGUIDES AND OPTICAL COMPONENTS PRODUCED BY SAID METHOD
PROCEDE DE PRODUCTION DE COMPOSANTS OPTIQUES AVEC GUIDES D'ONDES OPTIQUES ACCOUPLES, ET COMPOSANTS OPTIQUES PRODUITS SELON CE PROCEDE

(30) Priorität: 29.02.1996 DE 19607671
(43) Veröffentlichungstag der Anmeldung: 16.12.1998
(73) Patentinhaber: INSTITUT FÜR MIKROTECHNIK MAINZ GmbH, 55129 Mainz-Hechtsheim (DE)
(72) Erfinder: PAATZSCH, Thomas, D-55116 Mainz (DE); SMAGLINSKI, Ingo, D-55118 Mainz (DE)
(74) Vertreter: Fuchs Mehler Weiss & Fritzsche
(86) Internationale Anmeldenummer: EP9701020
(87) Internationale Veröffentlichungsnummer: WO97032229

(56) Entgegenhaltungen:
- EP-A- 0 403 896
- EP-A- 0 560 043
- ECOC '93 PROCEEDINGS OF THE 19TH EUROPEAN CONFERENCE ON OPTICAL COMMUNICATION, 12. - 16.September 1993, MONTREUX,CH, Seiten 437-440, XP000391566 P. DANNBERG ET AL.: "Passive polymeric components fabricated by embossing technique"
- SPIE PROCEEDINGS, Bd. 1973, 6. - 8.April 1993, Seiten 94-102, XP000677264 A. ROGNER: "Precision components for optical fiber connections fabricated by the LIGA process"

## Beschreibung

Die Erfindung betrifft ein Verfahren zur Herstellung von optischen Bauteilen nach dem Oberbegriff des Anspruchs 1 sowie nach diesem Verfahren hergestellte optische Bauelemente nach dem Oberbegriff des Anspruches 12. Derartige Bauelemente können beispielsweise in der optischen Nachrichtentechnik oder in der Sensorik eingesetzt werden.

Die Übertragung von Signalen und Daten in der Nachrichtentechnik und Sensorik erfolgt zunehmend auf optischer Basis. Anstelle von elektrischen Verbindungen werden mit Hilfe von Lichtwellenleitern optische Verbindungen geschaffen, die in ihrer Gesamtheit ein optisches Netzwerk darstellen. Zum Aufbau eines solchen Netzes werden verschiedenste Komponenten in großen Stückzahlen zu möglichst geringen Preisen benötigt: dazu zählen u.a. Verbindungen (Stecker, Spleiße), Signalaufteiler (Verzweiger), Wavelength-Divisions-Multiplexer (WDM) und Schalter.

Lichtwellenleiter setzen sich aus einem sogenannten Wellenleiterkern und einem Wellenleitermaterial zusammen und sind in der Regel aus Glas oder Kunststoff. Der Transport des optischen Signals findet dabei im wesentlichen im Kern des Lichtwellenleiters statt. Je nach Übertragungswellenlänge und Größe bzw. Brechzahlen des Lichtwellenleiters werden eine oder mehrere optische Moden geführt. Insbesondere im Bereich der Sensorik und der Fernübertragung von Daten (Übertragungsbandbreite) wird eine einmodige Übertragung benötigt, welche die Verwendung sogenannter einmodiger Lichtwellenleiter voraussetzt.

Solche einmodigen Lichtwellenleiter weisen bei den gängigen Wellenlängen (0,4 - 1,6 µm) Kernabmessungen im Bereich 2 - 10 µm auf.

Besonders hohe Anforderungen werden aufgrund der kleinen Kernabmessungen an die Verbindungen von einmodigen Lichtwellenleitern miteinander bzw. mit optischen Komponenten gestellt. Für Anwendungen in der optischen Nachrichtentechnik ist es dabei erforderlich, für die Position der Faser in lateraler Richtung eine Genauigkeit von ± 1µm und für die Winkelausrichtung eine Genauigkeit von ± 0,5° einzuhalten. Solche Toleranzen können beispielsweise für Faserbändchen-Stecker (Faserbändchen: Kabel mit mehreren Lichtwellenleitern) dadurch erreicht werden, daß der Stecker mit Positionierstrukturen für die Lichtwellenleiter im Spritzgußverfahren unter Zuhilfenahme eines hochpräzisen, mikrotechnisch hergestellten Formwerkzeuges gefertigt wird (H.-D. Bauer, L. Weber, W. Ehrfeld: "LIGA for Applications for Fibre Optics; High Precision Fibre Ribbon Ferrule"; MST News 10 (1994), S. 18-19).

Für die passive und aktive Verarbeitung von optischen Signalen kommen zunehmend auch integriert-optische Bauteile zum Einsatz. Dazu wird eine Lichtwellenleiter-Anordnung in ein Substrat integriert, welche eine bestimmte Funktion (Signalverzweigung, Schaltung, etc.) erfüllt. Die Ankopplung von Lichtwellenleitern an das Bauteil (unter Einhaltung der oben angegebenen Toleranzen!) kann z.B. durch einen aktiven oder semi-aktiven Montageprozeß der Bauteile erfolgen, in dem die Position der Faser durch Messung der eingekoppelten und am Ausgang gemessenen Lichtleistung variiert und dabei auf einen minimalen Verlust optimiert wird. Der Aufwand eines solchen Herstellungsverfahrens ist aber verhältnismäßig hoch.

Eine sehr kostengünstige Lösung für die Herstellung solcher Bauteile liegt in der Verwendung polymerer Materialien, welche in einem Abformverfahren, wie z.B. Spritzguß, Spritzprägen, Heißprägen, Reaktionsguß, etc. verarbeitet werden. In diesem Zusammenhang ist es besonders vorteilhaft, neben den wellenleitenden Bereichen auch Faserführungsbereiche in das Bauteil zu integrieren, in welche die Fasern ohne Nachjustage lediglich eingebracht werden müssen. Eine solche Faserankopplung bezeichnet man auch als selbstjustierende oder passive Faser-Chip-Kopplung.

Besonders vorteilhaft für die Herstellung der Bauelemente ist die Verwendung der LIGA-Technik. Diese Technik beinhaltet die drei Verfahrensschritte Lithographie, Galvanik und Abformung. Im ersten Schritt wird ein Resist auf ein Substrat aufgebracht und durch eine geeignete Maske z.B. mit Synchrotonstrahlung belichtet. Nach der Entwicklung wird in den aus dem Resist herausgelösten Bereichen galvanisch Metall abgeschieden, wodurch ein Formeinsatz als Negativ der ursprünglichen Struktur entsteht. Dieser Formeinsatz wird in einem Abformverfahren (z.B. Spritzgut) zur Herstellung von Formteilen aus z.B. Kunststoff verwendet. Mit Hilfe der LIGA-Technik können Formteile mit einer sehr hohen Präzision (< 1µm) hergestellt werden. Eine detaillierte Beschreibung der LIGA-Technik findet sich beispielsweise in: W. Ehrfeld, M. Abraham, U. Ehrfeld, M. Lacher, H. Lehr: "Materials for LIGA-Products", Micro-Electrical Mechanical Systems: An Investigation of Microstructures, Sensors, Actuators,../Bearb. von W. Benecke, Hrsg. v. The Institute of Electrical and Electronic Engineers, Piscataway, NJ; IEEE Press, 1992.

Aus der DE 42 12 208 ist ein Verfahren zur Herstellung eines optischen Polymerbauelementes bekannt, bei welchem ein Mikrostrukturkörper mittels Si-Mikromechanik und Excimerlaserbearbeitung hergestellt wird. Aus diesem Mikrostrukturkörper wird durch Galvanoformung ein Formeinsatz erzeugt, welcher zur Abformung in ein polymeres Material verwendet wird. Die Mikrostruktur weist dabei eine v-förmige Faseraufname und einen Graben für den Wellenleiter auf.

In der DE 43 44 179 C1 wird eine Koppelvorrichtung zwischen einer Glasfaser und einem auf einem Substrat integrierten dielektrischen Wellenleiter beschrieben. Zwei mit V-förmigem bzw. U-förmigem Graben versehene, identische Bauteile müssen exakt zusammengefügt werden, damit die Gräben übereinander angeordnet sind und den gesamten Gasfasertaper aufnehmen. Dies bedeutet einen erheblichen Montageaufwand. Um im eingeschobenen Zustand eine exakte Lagefixierung der Glasfaser sicherzustellen, ist eine Verjüngung der beiden Gräben vorgesehen.

In A. Rogner, SPIE, Vol. 1973, S. 94 - 102 geht es um im LIGA-Verfahren hergestellte Präzisionskomponenten für das Koppeln optischer Fasern. Dort wird ein gestuftes Formteil mit zwei rechteckigen Gräben vorgeschlagen. Der eine Graben dient der Aufnahme eines nicht verjüngten Faserendes, das auf einen im zweiten Graben integrierten Wellenleiter ausgerichtet wird. Dies ist nur mit glattgeschnittenen Faserenden möglich. Um die Faser vollständig aufzunehmen, werden zwei identische Formteile übereinander angeordnet.

In der DE 42 17 526 A1 wird ein Verfahren zur Herstellung von Bauelementen für Wellenleiternetze beschrieben, bei welchen Faserführungsstrukturen und Wellenleitervorformen mittels eines gestuften Formeinsatzes in Abformtechnik hergestellt werden. Als bevorzugtes Herstellungsverfahren für den Formeinsatz wird die Röntgentiefenlithographie unter Verwendung eines gestuften Substrats mit nachfolgender galvanischer Abformung angegeben. Die Herstellung des gestuften Formeinsatzes ist auch Gegenstand der Patentanmeldung DE 43 10 296.

Nachteilig an den Verfahren und Vorrichtungen aus dem Stand der Technik ist, daß Faseraufnahme und Wellenleiter sich auf zwei, durch eine Stufe getrennten Ebenen befinden. Ein solcher Körper ist aber zur Aufnahme von Fasertapern völlig ungeeignet, da keine sichere Positionierung der Taperspitze gewährleistet ist. Schon aufgrund des geringen Durchmessers des Fasertapers im Spitzenbereich kann es beim Einbringen des Fasertapers leicht zu einer Biegung kommen, welche die Position der Taperspitze verändern und damit zu einer hohen Einfügedämpfung führen würde. Außerdem ist die Form der beschriebenen Aufnahmen nicht an das Profil der Fasertaper angepaßt, so daß eine Überkopplung der optischen Welle zwischen Fasertaper und Fäsertaper-Aufnahme, wie in DE 43 44 179, nicht möglich ist.

Eine Vorrichtung zur Kopplung von Fasertapern an optische Wellenleiter ist aus der DE 43 44 179 bekannt. Die beschriebene Vorrichtung weist eine Fasertaper-Aufnahme auf, die an das Profil der Fasertaper angepaßt ist. Dadurch wird gewährleistet, daß eine Überkopplung des optischen Feldes zwischen Fasertaper und Fasertaper-Aufnahme möglich ist. Der Querschnitt der beschriebenen Fasertaper-Aufnahme ist kreisförmig bzw. trapezförmig (als zwei übereinanderliegende V-Formen) angelegt.

Ein Verfahren zur Herstellung der vorgeschlagenen Koppelvorrichtung wird in der DE 43 44 179 nicht angegeben. Gerade für die Herstellung der Vorrichtung sind aber die angegebenen Querschnitts-Formen für die Faseraufnahme besonders ungeeignet. Sie sind mit bekannten Fertigungsverfahren der Feinwerk- und Mikrotechnik nicht in der gewünschten Präzision und mit den benötigten kleinen Wandrauhigkeiten fertigbar. Außerdem besitzt die Vorrichtung den entscheidenden Nachteil, daß sie der Fasertaper-Aufnahme zugeordnete Gräben in Grund- und Deckplatte vorsieht. Neben der Grundplatte muß daher auch für die Deckplatte ein eigener Formeinsatz hergestellt und dieser zur Abformung der Deckplatten-Formteile verwendet werden. Weiterhin müssen für eine gute Funktion der Kopplung Grund- und Deckplatte mit sehr hoher Genauigkeit.(ca. 1µm) aufeinandergesetzt und fixiert werden. Eine solche Forderung ist aber technologisch nur durch einen sehr hohen Aufwand (aktives Positionieren der Platten oder Selbstjustierung durch hochpräzise Positionselemente) machbar.

Die EP 0 618 502 A1 beschreibt ein Verfahren zur Herstellung gestufter Formeinsätze, bei dem mit zwei Resistschichten und zwei Bestrahlungsvorgängen gearbeitet wird, wobei zwischendurch in selektiven Bereichen Metall abgeschieden wird und unterschiedliche Zwischenschichten aufgebracht werden. Für die Herstellung von Fasertaperaufnahmen ist dieses Verfahren nicht geeignet.

Es ist daher Aufgabe der Erfindung, ein einfaches Verfahren zur Herstellung eines optischen Bauelementes mit Fasertaper-Aufnahme anzugeben. Es ist weiterhin Aufgabe der Erfindung, ein optisches Báuelement mit einer Fasertaper-Aufnahme zu schaffen, welches sich mit dem angegebenen Verfahren besonders vorteilhaft herstellen läßt und welches die oben beschriebenen Nachteile nicht aufweist.

Die Aufgabe wird von einem Verfahren nach Anspruch 1 sowie mit einem optischen Bauelement gemäß Anspruch 12 gelöst.

Das erfindungsgemäße Verfahren ist dadurch gekennzeichnet, daß zur Herstellung des Mikrostrukturkörpers ein Substrat mit einem strahlungsempfindlichen Material derart beschichtet wird, daß die Schichtdicke des strahlungsempfindlichen Materials in einer ersten Richtung über mindestens einen Bereich des Substrats kontinuierlich abnimmt (Übergangsbereich), und daß in das beschichtete Substrat durch einen Belichtungsprozeß eine im wesentlichen rechteckige grabenförmige Struktur eingebracht wird, welche sich in einer zweiten Richtung über mindestens einen Bereich kontinuierlich verjüngt (Verjüngungsbereich) und daß der Belichtungsprozeß so geführt wird, daß der Verjüngungsbereich und der Übergangsbereich zur Deckung kommen.

Vorzugsweise wird das beschichtete Substrat durch mindestens eine Maske mit mindestens einem absorberfreien Bereich hindurch belichtet, wobei der absorberfreie Bereich sich in einer zweiten Richtung über mindestens einen Bereich kontinuierlich verjüngt (Verjüngungsbereich) und die Maske zum beschichteten Substrat derart ausgerichtet wird, daß die erste und die zweite Richtung parallel oder anti-parallel liegen. Es ist auch möglich, daß beide Richtungen einen Winkel >0 einschließen. Die Fasertaper-Aufnahme kann auf Grundlage der LIGA-Technik mit sehr hoher Präzision und kleiner Wandrauhigkeit gefertigt werden. Außerdem kann die Fasertaper-Aufnahme an das Profil der Fasertaper angepaßt und somit die oben beschriebene Überkopplung von Fasertaper und Aufnahme gewährleistet werden.

Weil das Verfahren sich weiterhin dadurch auszeichnet, daß Formteile durch Abformung aus einem formbaren Material hergestellt werden und Kernmaterial und Fasertaper in die Formteile eingebracht werden sowie eine Deckplatte aufgesetzt wird, ist eine sehr kostengünstige Herstellung der optischen Bauteile möglich. Das Verfahren ist außerdem für Massenproduktion geeignet.

Vorzugsweise geht der Übergangsbereich des strahlungsempfindlichen Materials stufenlos in einen zweiten Bereich mit konstanter Höhe über. Auch der Verjüngungsbereich auf der Maske geht vorzugsweise stufenlos in einen zweiten, für den Wellenbereich vorgesehenen absorberfreien Bereich konstanter Breite über.

Da in einer vorteilhaften Ausgestaltung der Erfindung ein Substrat mit profilierter Oberseite verwendet wird und die Beschichtung des Substrates mit strahlungsempfindlichem Material in der Weise erfolgt, daß die Oberfläche des strahlungsempfindlichen Materials eben ist, kann die Höhe des strahlungsempfindlichen Materials (und damit die Grabenhöhe der Fasertaper-Aufnahme) mit sehr hoher Präzision eingestellt werden. Es ergibt sich außerdem der entscheidende Vorteil, daß zur Herstellung von profiliertem Substrat mit Beschichtung weitverbreitete und kostengünstige Fertigungsverfahren, wie z.B. Drahterosion und Poliertechnik eingesetzt werden können.

Vorteilhaft ist die Beschichtung des Substrats mit einem röntgenempfindlichen Resist und die Verwendung von Synchrotronstrahlung zur Belichtung. Durch dieses Verfahren wird eine sehr hohe Strukturgenauigkeit und eine kleine Rauhigkeit der Seitenwände gewährleistet. Dies ist insbesondere für die Funktion von wellenleitenden Bereichen (z.B. Y-Verzweiger) wichtig. Es ist aber auch möglich, einen Photolack in Verbindung mit konventioneller UV-Lithographie oder reaktives Ionenätzen (RIE) zu verwenden. Weiterhin kann auch auf die Maske verzichtet werden und die Struktur beispielsweise mittels Elektronenstrahlschreiber oder Laserschreiber direkt in den Resist geschrieben werden.

Da eine Faser-Wellenleiterkopplung dadurch erreicht werden kann, daß auf dem Substrat an den der Taperaufnahme zugeordneten Bereich eine zweiter Bereich für Wellenleiter vorgesehen wird, und die weitere Fertigung von Fasertaper-Aufnahme und Wellenleiter in einem Stück erfolgt, kann eine sehr hohe Präzision insbesondere an der Koppelstelle von Fasertaper-Aufnahme und Wellenleiter gewährleistet werden. Dadurch sind sehr kleine Werte für die Einfügedämpfung der Faser-Wellenleiterkopplung möglich.

Weil sich die Verjüngung der Fasertaper-Aufnahme in eine Raumrichtung dadurch ergibt, daß im Herstellungsverfahren eine kontinuierlich abnehmende Resisthöhe eingestellt wird, sind die Gräben für die Fasertaper-Aufnahme lediglich im Formteil, nicht aber in der Deckplatte enthalten. Als Deckplatte reicht daher ein ebenes Plättchen aus, welches sehr einfach beispielsweise durch Sägen aus einer Platte gewonnen werden kann. Außerdem ist kein präzises Aufeinandersetzen von Grund- und Deckplatte notwendig, weshalb ein sehr einfacher und kostengünstiger Montageprozeß (Kleben, Laserschweißen) möglich ist.

Weil das Einbringen der Fasertaper in die Aufnahme so erfolgen kann, daß zunächst Kernmaterial eingebracht, Grund- und Deckplatte aufeinandergesetzt, und dann die Fasertaper in die Fasertaper-Aufnahme bis zum Anschlag eingeschoben werden, findet eine Selbstjustierung der Fasertaper zur Aufnahme statt (passive Faser-Chip-Kopplung!). Dadurch wird der Montageprozeß weiterhin erheblich vereinfacht.

Da das optische Bauelement eine Fasertaper-Aufnahme mit im wesentlichen rechteckigen Querschnitt aufweist, kann sie durch das erfindungsgemäße Verfahren besonders einfach hergestellt werden.

Außerdem ist die Fasertaper-Aufnahme des optischen Bauteils an das Fasertaper-Profil angepaßt. Dadurch ist eine Überkopplung der optischen Welle zwischen Fasertaper und Fasertaper-Aufnahme (s. DE 43 44 179 A1) möglich, welche eine sehr geringe Einfügedämpfung und eine Vielzahl von neuen Anwendungen gewährleistet. Dazu zählen: die verlustarme Kopplung von Fasern an Wellenleiter mit beliebigen Abmessungen und Brechzahlen oder auch an Wellenleiter mit elliptischem Feldprofil; Bereitstellen einer Faserankoppel-Vorrichtung auch für Wellenleiter, die in einer anderen Technik (z.B. eindiffundierte Wellenleiter aus Glas, SiON-Wellenleiter in Si-Technik) hergestellt wurde; verlustarmer Stecker zur Kopplung von Faserbändchen; Einkoppelung von Licht in ein optisches Bauteil, welches Freistrahlstrecken für das Licht aufweist, Formung des Austrittskanals einer Laserdiode beispielsweise zur Einkopplung des Lichts in eine Glasfaser; Einkopplung einer optischen Welle in eine Sensorplattform oder ein mikrotechnisches Analysesystem.

Auf das durch Abformung hergestellte Formteil wird eine Deckplatte aufgebracht. Das erfindungsgemäße Bauelement hat dabei den großen Vorteil, daß in der Deckplatte keine grabenförmigen Öffnungen für die Fasertaper-Aufnahme vorgesehen sind. Aus diesem Grund ist es nicht notwendig, Grund- und Deckplatte mit hoher Präzision zueinander auszurichten.

Besonders vorteilhaft ist es dabei, wenn lediglich das Formteil, nicht aber die Deckplatte Gräben für die Fasertapet-Aufnahme aufweist.

Das erfindungsgemäße Verfahren betrifft optische Bauelemente, die dadurch gekennzeichnet sind, daß die Fasertaper-Aufnahme einen Graben mit rechteckigem Querschnitt aufweist und Grabenhöhe und Grabenbreite über mindestens einen Bereich kontinuierlich abnehmen. Solche Bauelemente können beispielsweise passive oder aktive integriert-optische Komponenten (mxn-Verzweiger, Schalter, Modulatoren, Wellenlängen-Multiplexer-Demultiplexer, Sensoren, etc.), Faserverbindungselemente (Spleiße, Faserstecker) oder optische Bauteile, die Bereiche mit Freistrahloptiken (z.B. Matrixschalter, Interferometer, etc.) beinhalten, sein.

Die Herstellung der optischen Bauelemente erfolgt auf Basis der LIGA-Technik. Erfindungsgemäß wird zunächst ein Substrat mit einem Resist beschichtet, wobei die Höhe des Resists zumindest in einem der Fasertaper-Aufnahme zugeordneten Bereich kontinuierlich abnimmt. Daneben können aber noch weitere Bereiche mit beispielsweise konstanter Resisthöhe existieren. Die Einstellung der Resisthöhe erfolgt vorteilhaft mittels feinmechanischer Verfahren wie Erodieren, Polieren oder Polierfräsen.

Im Anschluß wird durch Galvanoformung ein Formwerkzeug hergestellt und dieser in an sich bekannter Weise zur Abformung von Formteilen in einen Formstoff verwendet. Dazu kommen Abformverfahren wie Spritzguß, Heißprägen, Spritzprägen, Reaktionsguß, etc. in Betracht.

In einer vorteilhaften Ausgestaltung wird eine Belichtung des beschichteten Substrates durchgeführt. Dazu wird eine Maske verwendet, welche absorberfreie Bereiche aufweist, die sich zumindest in einem der Taperaufnahme zugeordneten Bereich im wesentlichen kontinuierlich verjüngen. Zur Belichtung werden Maske und beschichtetes Substrat so zueinander ausgerichtet, daß die sich verjüngenden, der Taperaufnahme zugeordneten Bereiche jeweils zur Deckung kommen. Nach der Belichtung erfolgt in an sich bekannter Weise das Entwickeln des Resists.

Zur Herstellung einer Faser-Wellenleiter-Kopplung ist es vorteilhaft, wenn der Bereich mit abnehmender Resisthöhe stufenlos in einen zweiten Bereich mit insbesondere konstanter Resisthöhe übergeht. Weiterhin ist es vorteilhaft, wenn der sich verjüngende, absorberfreie Bereich auf der Maske stufenlos in einen zweiten, für den Wellenleiter vorgesehenen Bereich übergeht. In diesen zweiten Bereich kann die Funktion der integriert-optischen Komponente (z.B. Y-Verzweiger) integriert sein. Die Wellenleiter können einen quadratischen oder einen rechteckigen Querschnitt annehmen. Die Verwendung von Rechteckwellenleitern ist besonders vorteilhaft, wenn die Polarisation der geführten Welle erhalten werden soll.

In einer besonderen Ausgestaltung des Verfahrens wird ein Substrat mit planer Unterseite und profilierter Oberseite verwendet. Das Höhenprofil der Substratoberseite ist dabei so gestaltet, daß es zumindest in einem der Fasertaper-Aufnahme zugeordneten Bereich kontinuierlich zunimmt. Zur Herstellung einer Faser-Wellenleiter-Kopplung kann für den Wellenleiter mindestens ein zweiter Bereich mit im wesentlichen ebener Oberseite vorgesehen sein. Vorteilhaft ist. dabei, wenn dieser Bereich parallel zur Unterseite des Substrats ausgerichtet wird. Die Herstellung des profilierten Substrats erfolgt beispielsweise mittels Drahterosion, mehrachsigem Polierfräsen, Ultrapräzisions-Frästechnik oder einem weiter unten erläuterten Verfahren.

Es ist weiterhin vorteilhaft, die Beschichtung des Substrats mit Resist so durchzuführen, daß die Oberseite des Resists eben ist und sich das gewünschte Höhenprofil des Resists als Differenz von profilierter Substratoberseite und Resistoberfläche ergibt. Zur Herstellung einer Faser-Wellenleiter-Kopplung kann es zudem vorteilhaft sein, die Resistoberfläche so einzustellen, daß sie im dem Wellenleiter zugeordneten Bereich parallel zur Substratoberseite ist. Auf diese Weise wird eine konstante Wellenleiterhöhe gewährleistet. Es kann aber auch gewünscht sein, die Resisthöhe im Wellenleiterbereich zu variieren und somit eine sich ändernde Wellenleiterhöhe zu realisieren, wenn dies für die Funktion des Bauteils von Vorteil ist. Zur Beschichtung wird der Resist beispielsweise in einem Gießprozeß aufgetragen und im Anschluß mittels Polieren oder Polierfräsen abgearbeitet. Besonders vorteilhaft ist es dabei, wenn die Resistfläche parallel zur Unterseite des Substrats ausgerichtet wird.

Neben dem Substrat kann auch die Oberseite des Resists z.R durch Polierfräsen mit einem Höhenprofil versehen werden. Dadurch ergeben sich weitere Möglichkeiten der Ausgestaltung des optischen Bauelementes.

Um die spätere Nachbearbeitung des Formeinsatzes zu reduzieren, ist es vorteilhaft, geringe Rauhigkeiten von Substratoberseite (entspricht Resistunterseite) und Resistoberseite einzustellen. Dabei ist allerdings die dem Fachmann bekannte Tatsache zu berücksichtigen, daß eine ausreichende Haftung des Resist auf der Unterlage gewährleistet sein muß. Die Reduzierung der Rauhigkeit kann durch an sich bekannte Polierverfahren erfolgen. Dabei kann es vorteilhaft sein, die Stärke des Substrats so zu wählen, daß es durch geringfügige elastische Biegung auf einer ebenen Polierscheibe aufgesetzt werden kann.

Das Einbringen der Fasertaper in die Fasertaper-Aufnahme erfolgt besonders vorteilhaft in der Weise, daß zunächst Formteil und Deckplatte aufeinander aufgesetzt und Kernmaterial eingebracht wird und im Anschluß die Fasertaper in die Öffnungen der Fasertapet-Aufnahmen bis zum Anschlag eingeschoben werden. Zum Einbringen der Fasertaper kann aber auch eine andere Reihenfolge der beschriebenen Verfahrensschritte gewählt werden.

Nach Einbringen des Fasertapers wird das Kernmaterial verfestigt.

Zur Herstellung des oben beschriebenen profilierten Substrats gibt es weitere Herstellungsverfahren, die im folgenden erläutert werden:

Ein Verfahren beinhaltet die Herstellung des Substrates mittels Excimerlaserbearbeitung. Dabei wird zunächst ein Substrat mit einem Resist beschichtet und dann die Resistoberfläche mit einem Excimerlaser bearbeitet. Durch Ablagerung unterschiedlicher Dosiswerte an verschiedenen Stellen der Resistoberfläche kann das Höhenprofil eingestellt werden. Durch nachfolgende galvanische Abformung wird das Profil in Metall übertragen. Mit Hilfe der Excimerlaserbearbeitung können auch weitere, für die Funktion des optischen Bauelementes notwendige Strukturen (Positionierhilfen, etc.) in das Substrat übertragen werden.

Als weiteres Verfahren kommt UV-Grauton-Lithographie in Betracht. Dabei wird eine Belichtung durch eine Maske mit kontinuierlich sich verändernder Absorption verwendet. Je nach lokal abgelagerter Dosis im Resist wird der Resist mehr oder weniger tief entwickelt, was zu einem variablen Höhenprofil führt. Durch nachfolgende galvanische Abformung kann das Profil im Metall übertragen werden.

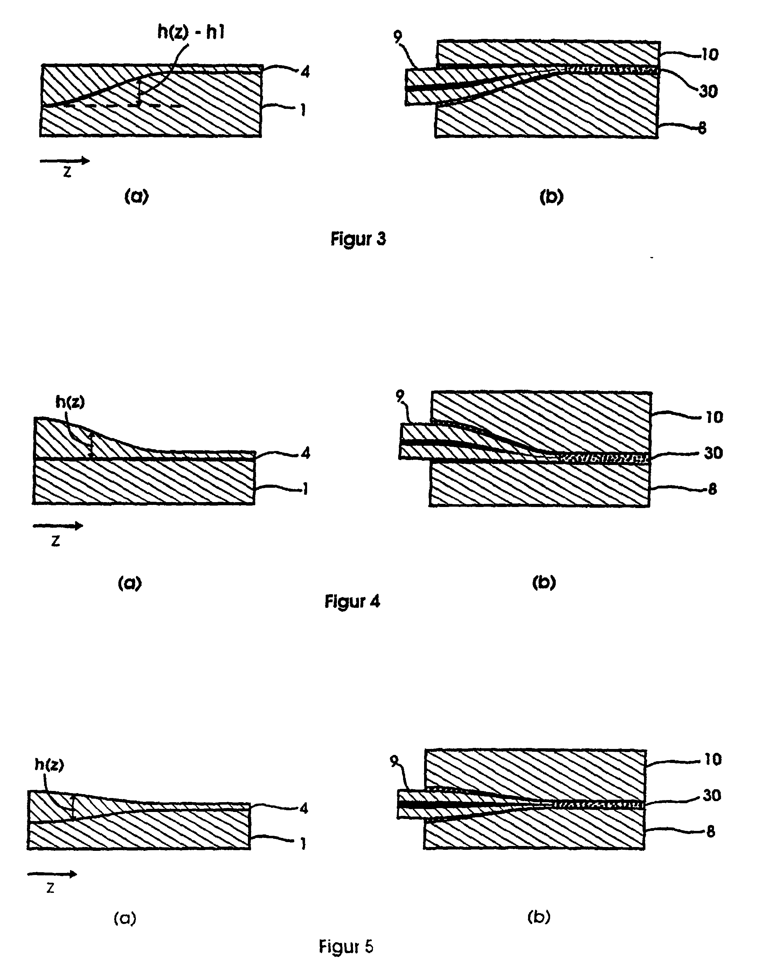

Als weiteres Verfahren zur Herstellung eines profilierten Substrats kommt die Röntgentiefenlithographie in Betracht. Besonders vorteilhaft ist dabei, das Querschnittsprofil des Substrats nach an sich bekannten Verfahren mit sehr hoher Präzision auf eine Röntgenmaske zu übertragen. Durch Belichtung eines Resist mit Synchrotronstrahlung, Entwicklung und galvanischem Auffüllen der entwickelten Bereiche erhält man das Substrat in "hochkantiger" Ausrichtung (Figur 3). Mit Hilfe von sogenannten ultratiefen Röntgenbelichtungen können somit Substratbreiten von mehreren mm erhalten werden.

Besonders vorteilhaft kann mit dem erfindungsgemäßen Verfahren ein optisches Bauteil mit mindestens einer Fasertaper-Aufnahme und mindestens einem angekoppelten Fasertaper hergestellt werden, wenn die Fasertaper-Aufnahme einen Graben mit im wesentlichen rechteckigem Querschnitt aufweist, wobei Grabenbreite und Höhe mindestens über einen Bereich kontinuierlich abnehmen.

In der erfindungsgemäßen Ausgestaltung des optischen Bauelementes ist die Abnahme von Grabenhöhe und Breite an das beim thermischen Ziehen von Fasern erhaltene Profil angepaßt. Dadurch wird gewährleistet, daß eine Überkopplung der optischen Welle zwischen Fasertaper und Fasertaper-Aufnahme möglich ist, wodurch eine Vielzahl an Anwendungen (s.o.) resultiert. Für eine solche Anpassung kann es beispielsweise von Vorteil sein, das Durchmesserprofil für eine größere Zahl von gezogenen Fasertapern zu vermessen und das Profil der Fasertaper-Aufnahme in etwa gleich der Summe aus Mittelwert und Standardabweichung der Meßwerte zu setzen. Dadurch ist es möglich, alle Fasertaper im Rahmen der typischen Schwankungsbreite der Fasertaper-Fertigung in die Aufnahme einzubringen. Je nach tatsächlichem Fasertaper-Profilverlauf wird der Fasertaper dann mehr oder weniger weit bis zum Anschlag an die Fasertaper-Aufnahme eingeschoben, wobei die Funktion der oben beschriebenen Überkopplung der optischen Welle erhalten bleibt.

Zur Herstellung einer Faser-Wellenleiterkopplung ist es vorteilhaft, wenn der sich verjüngende Graben der Fasertaper-Aufnahme stufenlos in einen zweiten, für den Wellenleiter vorgesehenen Graben übergeht.

In einer bevorzugten Ausführungsform ist der Graben der Fasertaper-Aufnahme allseitig umschlossen. Durch Wahl eines Materials mit geeigneten Brechungsindex für den Außenraum kann eine gute optische Funktion beispielsweise für eine Faser-Wellenleiter-Kopplung gewährleistet werden.

Ein allseitig umschlossener Graben für die Fasertaper-Aufnahme kann beispielsweise dadurch erzeugt werden, daß sich das optische Bauteil aus einem Formteil und einer Deckplatte zusammensetzt. Vorteilhaft ist, wenn die Fasertaper-Aufnahme so gestaltet ist, daß die Oberseite des allseitig umschlossenen Grabens eben ist. In einfacher Weise kann in diesem Fall dann für die Deckplatte ein im wesentlichen ebenes Plättchen verwendet werden.

In einer anderen bevorzugten Ausführungsform ist der für Fasertapet-Aufnahme vorgesehene Graben nach oben offen. Dadurch wird erreicht, daß die optische Welle zumindest teilweise an der Oberfläche des optischen Bauteils geführt wird. Ein solches optisches Bauteil kann sehr vorteilhaft für die Sensorik eingesetzt werden, da die Lichtwelle dann beispielsweise auf an der Oberseite stattfindende Veränderungen reagiert.

Vorteilhaft ist, wenn in die Fasertaper-Aufnahme ein zweites Material eingebracht ist, welches die Freiräume zwischen Fasertapet-Aufnahme und eingebrachtem Fasertaper ausfüllt. Im Falle einer Faser-Wellenleiterkopplung kann das eingebrachte Material vorteilhaft für den Kern des Wellenleiters verwendet werden.

In einer weiteren bevorzugten Ausführungsform reicht die Tapet-Aufnahme zumindest auf der verjüngten Seite über den Fasertaper hinaus. Hinter dem Fasertaper kann sich die Aufnahme dann beispielsweise weiter verjüngen, bis die Grabenhöhe einen Endwert h0 und die Breite einen Endwert b0 erreicht. An den Taper kann ein Wellenleiter mit den Abmessungen h0 und b0 angeschlossen sein, in welchen verlustarm eingekoppelt wird. Besonders vorteilhaft ist dabei, daß die Abmessungen des Wellenleiters beispielsweise auch wesentlich kleiner als der Kern der zum Einkoppeln verwendeten Faser sein könnten. Weiterhin vorteilhaft ist, daß b0 und d0 auch unterschiedliche Werte annehmen können, so daß auch verlustarm in einen Rechteck-Wellenleiter mit elliptischem Feld-Querschnitt eingekoppelt werden kann.

In einer weiteren bevorzugten Ausführungsform weist die Fasertaper-Aufnahme am sich verjüngenden Ende eine Stirnfläche auf, die im wesentlichen senkrecht zur Achse des Fasertapers liegt. Dies ist besonders vorteilhaft, wenn das optische Bauteil ein Faserstecker ist oder Bereiche mit optischem Freistrahl aufweist.

Die Erfindung wird nachfolgend anhand der in den Zeichnungen dargestellten Ausführungsbeispiele näher erläutert. Es zeigen:
- Fig. 1: Profil von durch Ziehen in der Gasflamme hergestellten Fasertapern und ein Diagramm, in dem der Durchmesser d in Abhängigkeit der Taperlänge aufgetragen ist,
- Fig. 2: Herstellung einer Faser-Wellenleiterkopplung in LIGA-Technik,
- Fig.3-5: verschiedene Ausführungsformen der Fasertaper-Aufnahme.
- Fig. 6: Herstellung des profilierten Substrats mittels Röntgentiefenlithographie,
- Fig. 7: einen optischen Faserbändchen-Stecker,
- Fig. 8: einen Kreuzschienenverteiler,
- Fig. 9: eine Ankoppelvorrichtung für Wellenleiter-Bauteile in Silizium und
- Fig. 10: eine Ankoppelvorrichtung für einen Sensor.

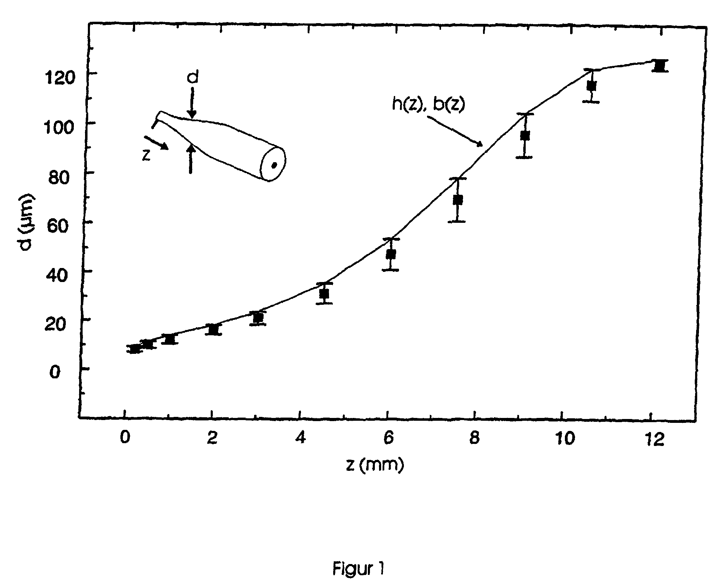

Figur 1 zeigt das Profil von Fasertapern, die durch einen an sich bekannten Ziehprozeß in der Gasflamme hergestellt wurden. Das Diagramm enthält Mittelwert und Standardabweichung des Durchmessers an verschiedenen Stellen für ca. 90 Fasertaper. Aus den Durchmesserschwankungen von ca. ± 2 µm im vorderen Teil und max. ± 9 µm im mittleren Bereich der Taper ergibt sich das bevorzugte Profil für die Auslegung der Taperaufnahme h(z), b(z).

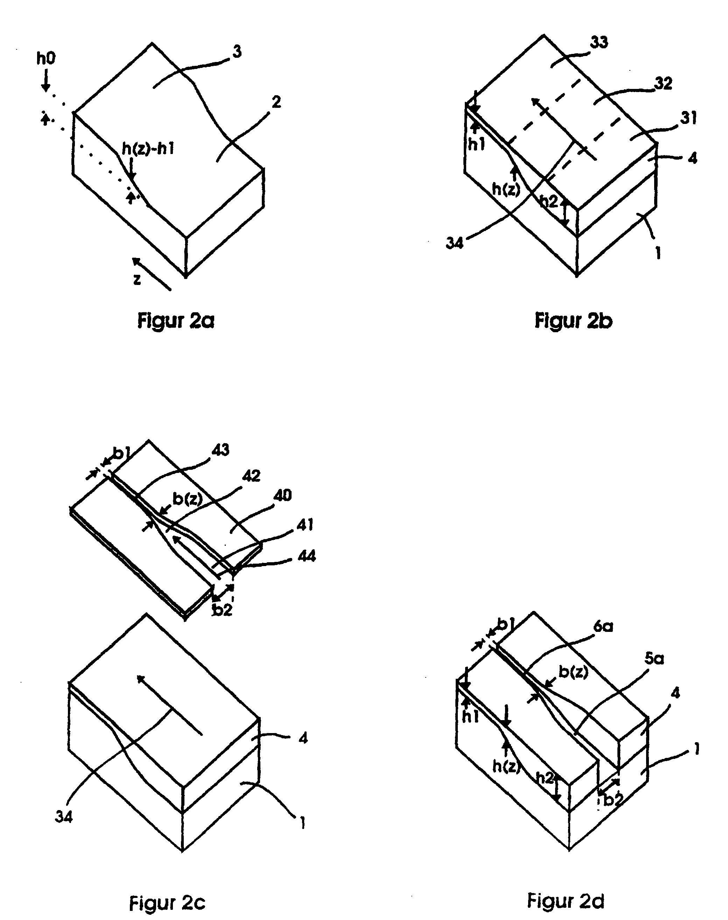

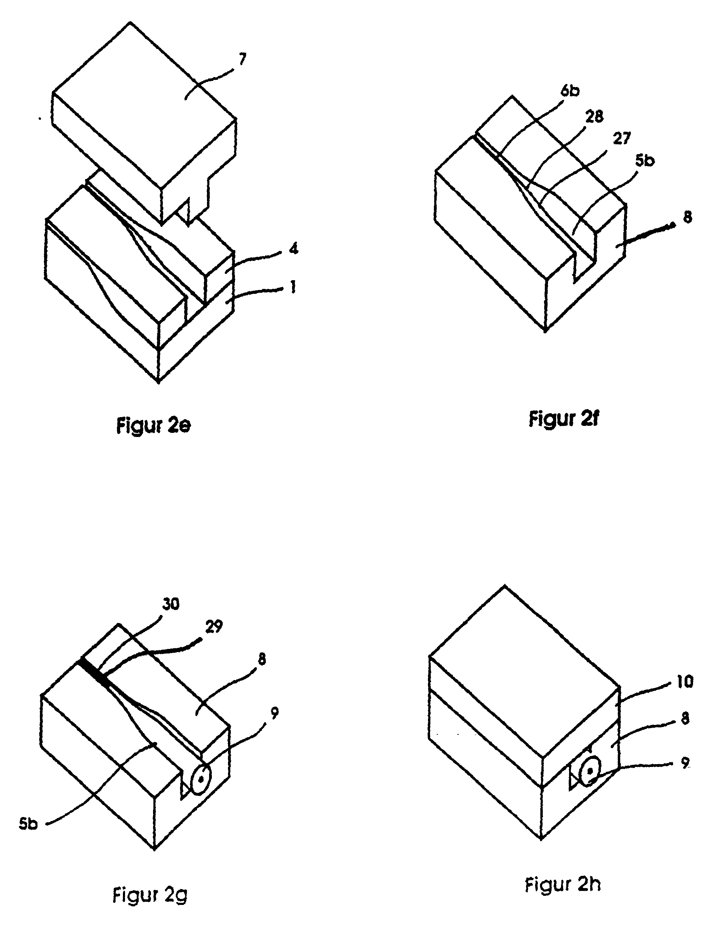

In Figur 2 sind die einzelnen Herstellungsschritte einer bevorzugten Ausführungsform der Fasertaper-Aufnahme mit daran anschließendem Wellenleiter dargestellt. Grundlage ist die bereits im Stand der Technik erläuterte Herstellung von polymeren Wellenleitern in LIGA-Technik. Es werden nur die Herstellungsschritte ausführlich erläutert, die im Rahmen der Erfindung neu sind.

Im ersten Schritt wird das in Fig. 2a gezeigte profilierte Substrat 1 beispielsweise mittels Drahterosion oder Polierfräsen aus z.B. Kupfer hergestellt. Die bevorzugte Profilform h(z) im Bereich der Fasertaperaufnahme 2 ist in Figur 1 angegeben. Im Wellenleiterbereich 3 wird eine ebene Plattform mit konstanter Profilhöhe h0 eingestellt. An die feinmechanische Bearbeitung kann noch ein Polierprozeß angeschlossen werden, um die Rauhigkeit der Substratoberfläche zu vermindern. Dies hat den Vorteil, daß dadurch der Aufwand für die Nachbearbeitung des Formwerkzeugs 7 (s. Figur 2e) verringert wird.

In der Figur 2b ist das mit dem Resistmaterial 4 beschriebene Substrat 1 dargestellt. Das Resistmaterial kann in drei Bereiche 31, 32, 33 unterteilt werden. Der Bereich 31 kennzeichnet den dicken Bereich, der über einen Übergangsbereich 32 in einen dünnen Bereich 33 übergeht. Die damit verbundene Richtung, die als erste Richtung bezeichnet wird, ist mit dem Bezugszeichen 34 gekennzeichnet.

Um eine ausreichende Haftung des Resists 4 auf dem Substrat 1 zu gewährleisten, kann, wie aus dem Stand der Technik bekannt, ein Haftvermittler aufgebracht werden und die Rauhigkeit der Substratoberfläche in obigem Polierprozeß auf einen geeigneten Wert eingestellt werden. Die Einstellung der Resisthöhe mittels feinmechanischer Bearbeitungsmethoden wie Polierfräsen oder Polieren erfolgt in der Weise, daß die Resistoberfläche eben ist und parallel der Substratoberfläche im Wellenleiterbereich 3 liegt (s. Figur 2a). Die Höhe h1 beträgt beispielsweise 8 µm und entspricht im wesentlichen der zu realisierenden Wellenleiterhöhe.

In der Figur 2c ist das in der Figur 2b beschichtete Substrat 1 dargestellt. Über dem Resistmaterial 4 wird eine Maske 40 angeordnet, die einen absorberfreien Bereich aufweist, der ebenfalls drei Bereiche 41, 42 und 43 umfaßt. Der Bereich 41 entspricht dem späteren Bereich für die Taper-Aufnahme und geht in den Übergangsbereich 42 über, an den sich der spätere Wellenleiterbereich 43 anschließt. Die hierdurch festgelegte zweite Richtung ist durch den Pfeil 44 gekennzeichnet. Die Maske 40 wird so über dem Resistmaterial 4 angeordnet, daß die beiden Richtungen 34 und 44 parallel zueinander liegen.

Nach der Ausrichtung der Maske 40 erfolgt die Belichtung mit Synchrotronstrahlung. Die verwendete Röntgenmaske 40 weist dabei absorberfreie Bereiche auf, die sich von einem Wert b2 von ca. 125 µm (Faserdurchmesser) auf die Wellenleiterbereiche b1 von beispielsweise 8µm verjüngen. Die variable Breite b(2) entspricht dabei bevorzugt dem in Figur 1 angegebenen Verlauf. Durch Simulatoren wurde gezeigt, daß für eine gute Funktion der Kopplung eine Genauigkeit von ± 50µm ausreicht. Nach der Bestrahlung wird der Resist entwickelt. Dabei werden die Bereiche für Fasertaper-Aufnahme 5a und Wellenleiter 6a freigelegt (s. Figur 2d).

Figur 2e zeigt das nach galvanischer Abformung und Ablösen vom Substrat 1 erhaltene Formwerkzeug 7. Um eine für die Wellenleitung ausreichende glatte Bodenfläche (s. Figur 2f) zu erreichen, wird die Unterseite des Formwerkzeuges 7 einem Polierprozeß unterzogen. Dabei kann es je nach verwendetem Poliertuch notwendig sein, das Formwerkzeug so elastisch zu verbiegen, daß der Wellenleiterbereich auf der ebenen Polierscheibe aufsetzt.

Figur 2f zeigt ein mittels des Formwerkzeuges 7 z.B. im Spritzgußverfahren hergestelltes polymeres Formteil 8 mit der Fasertaper-Aufnahme 5b und der Wellenleiteraufnahme 6b. Die Aufnahmen bilden einen Graben 27 mit rechteckigem Querschnitt, wobei der Graben 27 in Richtung Wellenleiteraufnahme 6b einen kontinuierlich ansteigenden Bereich 28 aufweist.

Figur 2g zeigt das polymere Formteil 8 mit eingebrachtem Fasertaper 9 sowie eingebrachtem Kernmaterial 30. Der Fasertaper 9 wird beim Einbringen in die Aufnahme leicht gebogen (genauere Erläuterungen in Fig. 4).

Figur 2h ist analog zu Figur 2g mit aufgesetzter ebener Deckplatte 10. Zur Fixierung wurde das Kernmaterial ausgehärtet.

Der in Figur 2 beschriebene Herstellungsprozeß bezieht sich lediglich auf die Faser-Wellenleiter-Kopplung einer integriert-optischen Komponente. Aus dem Stand der Technik ist bekannt, wie sich mittels mehrerer Faser-Wellenleiter-Kopplungen und integrierter Wellenleiter ein komplettes Bauteil herstellen läßt. Solche Bauteile können 1xN-Verzweiger, Schalter, WDM, etc. sein.

In den Figuren 3-5 sind verschiedene Ausführungsformen der Faser-Wellenleiter-Kopplungen dargestellt. Die Figuren 3a, 4a und 5a entsprechen dabei jeweils dem Querschnitt des beschichteten Substrats (vgl. Figur 2d) und Figur 3b, 4b und 5b dem Querschnitt der Komponente mit eingebrachtem Fasertaper (vgl. Figur 2h).

Figur 3 ist identisch mit der in Figur 2 beschriebenen Ausführungsform. Das profilierte Substrat I weist ein Oberflächenprofil h(z)-hl auf und die Oberfläche des Resists 4 ist eben. Zum Einbringen in die Taperaufnahme zwischen Formteil 8 und Deckplatte 10 wird der läper 9 gebogen. Diese Verbiegung ist aber außerordentlich gering, da auf der Länge des Tapers von z.B. 12mm lediglich ein Versatz von ca. 60µm notwendig ist. An der Fasertaper 9 schließt sich das Wellenleitermaterial 30 an.

In Figur 4 wird ein ebenes Substrat verwendet und ein Resisthöhenprofil h(z) beispielsweise durch mehrachsiges Polierfräsen eingestellt. Die Oberseite des durch diese Verfahrensvariante hergestellten Formteils 8 ist nicht mehr eben, sondern entspricht dem Profil h(z). Als Deckplatte 10 kann daher beispielsweise ein Plättchen mit dem inversen Oberflächenprofil h(z) verwendet werden. Es ist aber auch möglich, ein hinreichend dünnes, ebenes Plättchen zu verwenden, welches bei Aufsetzen auf das Formteil leicht gebogen wird. Die Deckplatte weist in diesem Fall keine Gräben für die Fasertaper-Aufnahme auf.

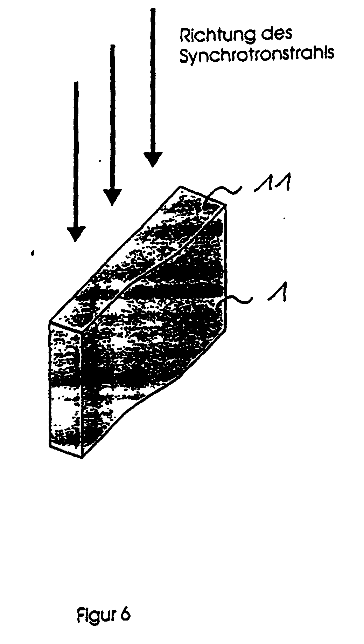

In Figur 5 sind sowohl Substrat 1 als auch Resistoberfläche profiliert, wobei sich insgesamt für die Resisthöhe der Profilverlauf h(z) ergibt. Dieses erfordert sowohl eine "Profilierung" von Substratoberfläche als auch der Resistoberfläche. Bei dieser Prozeßvariante ist es nicht notwendig, den Fasertaper 9 beim Einbringen in die Aufnahme zu verbiegen.

Figur 6 zeigt die Herstellung des profilierten Substrats durch Verwendung der Röntgentiefenlithographie. Dazu wird ein Substrat mit Resist beschichtet und die Belichtung mit Synchrotronstrahlung durchgeführt. Nach der Entwicklung werden die belichteten Bereiche aufgalvanisiert. Figur 6 zeigt das profilierte Substrat 1 und die Richtung des Synchrotronstrahls parallel zur zu profilierenden Oberfläche. Die Maske weist absorberfreie Bereiche in Form des Substratquerschnitts 11 auf. Durch neue Methoden der "ultratiefen" Röntgenlithographie können auch Substratplatten mit mehreren Millimetern Breite hergestellt werden.

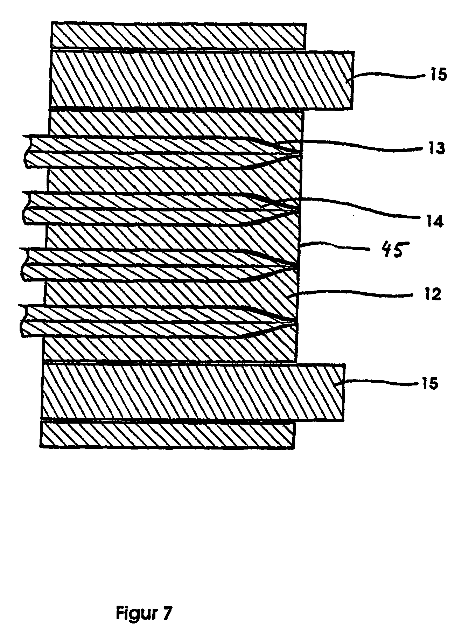

Figur 7 zeigt den Querschnitt eines Faserbändchensteckers, wie er in vergleichbarer Ausführung bereits aus dem oben zitierten Stand der Technik bekannt ist. Neu ist die Verwendung von Fasertapern 14 anstelle einfacher Fasern. Der Stecker setzt sich aus einem Formteil 12 mit Fasertaper-Aufnahmen 13, in welche die Fasertaper 14 eingebracht sind, zusammen. Außerdem weist der Stecker Positionierstifte 15 auf, die zum Ausrichten an ein entsprechendes Gegenstück vorgesehen sind.

An der Vorderseite des Fasersteckers ist eine ebene Stirnfläche 45 vorgesehen, die beispielsweise um 82° zur Achse des eingebrachten Fasertapers geneigt sein kann (Reduzierung der Rückflußdämpfung!). Besonders vorteilhaft ist, wenn die Abmessung der Fasertaperaufnahme an der Stirnfläche (mit z.B. 20µm) größer als der Kern der verwendeten Fasern ist. Dadurch ist auch der Durchmesser des optischen Feldes bei Austritt aus der Taperaufnahme größer als dies an einer Faserstirnfläche der Fall ist. Dies führt dazu, wie aus der Lichtwellenleiter-Kopplung bekannt, daß die Empfindlichkeit der Einfügedämpfung auf die laterale bzw. axiale Justierung der Steckerhälften bei größeren Felddurchmessern erheblich reduziert ist. Bei gleichem lateralen Versatz (Versatz senkrecht zur Achse der Fasertaper) kann somit durch die Verwendung von Fasertapern die Einfügedämpfung stark (z.B. um Faktor 10) reduziert werden.

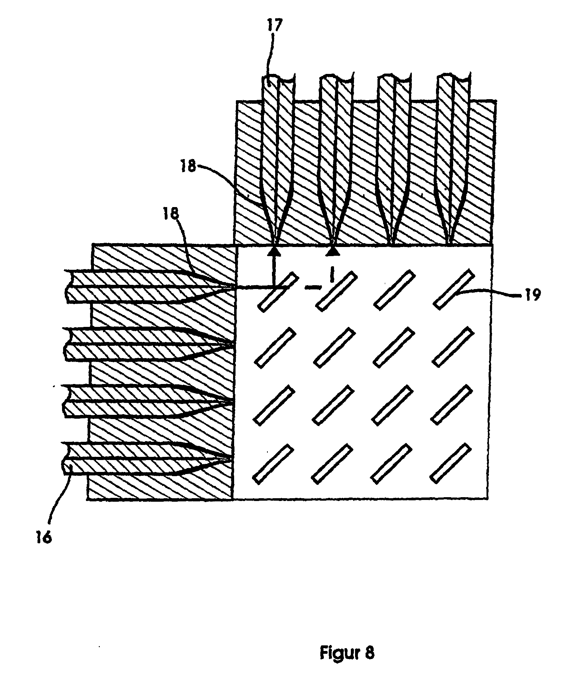

Figur 8 zeigt die Verwendung von Fasertapern in einem 4x4 Kreuzschienenverteiler. Der Kreuzschienenverteiler weist auf der Eingangsseite Fasertaper 16 und auf der Ausgangsseite Fasertaper 17 auf. Die Fasertaper werden durch die Taperaufnahmen 18 ausgerichtet und fixiert. Im Mittelbereich befinden sich "schaltbare" Spiegel 19, die individuell angesteuert auf Transmission oder Reflexion geschaltet werden können. Wie durch die beiden Strahlwege angedeutet, kann dadurch das einlaufende optische Signal auf eine beliebige Ausgangsfaser geschaltet werden.

Wie im Beispiel des Fasersteckers wird an der vorderen Seite der Fasertaper-Aufnahme eine Stirnfläche gefertigt. Besonders vorteilhaft ist dabei wiederum, die Taperaufnahme auf einen Minimalwert von z.B. 20µm an der Spitze zusammenzuführen, weil dadurch eine im Vergleich zur Faserstirnfläche wesentlich langsamere Aufweitung des Feldes im Freistrahlgebiet des Schalters stattfindet. Auf diese Weise wird die Durchgangsdämpfung des Schalters erheblich vermindert.

In der Figur 8 gezeigten Anordnung des Kreuzschienenverteilers können auch weitere optische Elemente (Linsen etc.) integriert werden, wenn dies von Vorteil ist.

Fasertaper können auch für andere Bauteile mit Freistrahloptiken (z.B. neuartige Verzweiger, WDM etc.) Verwendung finden. In allen Fällen ist besonders vorteilhaft, daß die axiale Aufweitung des Feldes vergleichsweise langsam erfolgt und eine geringe Präzision für die laterale Ausrichtung von miteinander zu köppelnden Fasertapern notwendig ist.

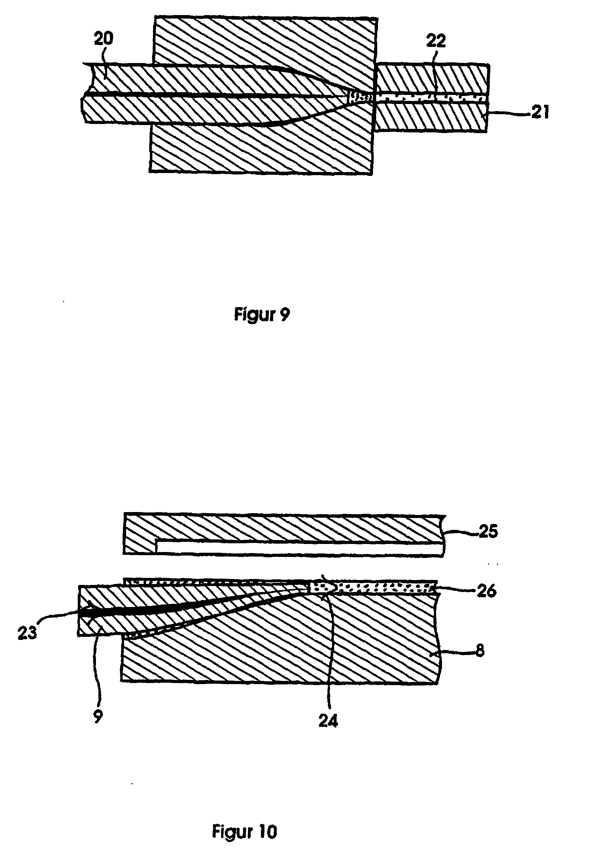

Figur 9 zeigt die Kopplung eines Fasertapers 20 an einen Halbleiterchip 21 mit integriertem Wellenleiter 22. Der Wellenleiter 22 kann beispielsweise in der an sich bekannten SiON-Technik auf Silizium hergestellt sein. Ein solcher Wellenleiter hat in der Regel Abmessungen, die wesentlich kleiner sind als der Kerndurchmesser einer Faser. Außerdem weist das im Wellenleiter geführte optische Feld oft einen elliptischen Querschnitt auf. Eine Kopplung einer Standardfaser an einen solchen Wellenleiter durch Verfahren aus dem Stand der Technik ist aufwendig und in der Regel mit hohen Verlusten behaftet.

Die Verwendung von Fasertapern hat dagegen den Vorteil, daß das optische Feld innerhalb der Taperaufnahme geformt und dabei beispielsweise dem Wellenleiterield ohne Verluste angepaßt werden kann. Dadurch können sehr kleine Einfügedämpfungen erreicht werden. Besonders vorteilhaft ist es, zur Kopplung eine Taperaufnahme zu verwenden, die länger als der Fasertaper ist. Während der Felddurchmesser im Bereich der Fasertaperspitze typisch bei 10µm liegt, wird es im dahinterliegenden Bereich der Aufnahme beispielsweise auf einen elliptischen Querschnitt mit Halbachsen von 1 x 2µm zusammenführt. Bei der Herstellung werden dazu die Profile h(z) und b(z) (vgl. Figur 2) so gewählt, daß sie im hinteren Bereich der Aufnahme von 10µm kontinuierlich auf 1 bzw. 2µm abnehmen.

Figur 10 zeigt die Ankopplung eines Fasertapers an einen Wellenleiter für die Sensorik. Die Vorrichtung weist ein Formteil 8 mit Fasertaper-Aufnahme und eingebrachtem Fasertaper 9 und dem Wellenleiterbereich 26 auf. Damit die optische Welle 23, 24 auf Veränderungen in der Umgebung reagieren kann, wird sie an der Oberfläche des Bauteils geführt. Die wellenleitenden Bereiche können beispielsweise in Form eines Mach-Zehnder-Interferometers ausgelegt sein, falls eine Phasenänderung der optischen Welle detektiert werden soll. Besonders vorteilhaft ist, daß die Oberfläche des Sensors Planar ist und somit in einfacher Weise beispielsweise eine Mikroküvette 25 auf dem Sensor angebracht werden kann.

Die Herstellung des Oberflächen-Wellenleiters kann beispielsweise dadurch erfolgen, daß als Deckplatte eine Glasplatte mit Trennschicht verwendet wird. Nach Verfestigung des Kernmaterials wird die Glasplatte vom Formteil abgehoben und der Wellenleiter freigelegt.

### Bezugszeichenliste:

- 1: Substrat
- 2: Fasertaper-Aufnahme
- 3: Wellenleiterbereich
- 4: Resist
- 5a,b: Fasertaper-Aufnahme
- 6a,b: Wellenleiteraufnahme
- 7: Formwerkzeug
- 8: Formteil
- 9: Fasertaper
- 10: Deckplatte
- 11: Seitenfläche
- 12: Formteil
- 13: Fasertaper-Aufnahme
- 14: Fasertaper
- 15: Positionierstift
- 16: Fasertaper
- 17: Fasertaper
- 18: Fasertaper-Aufnahme
- 19: Spiegel
- 20: Fasertaper
- 21: Halbleiterchip
- 22: Wellenleiter
- 23: optische Welle
- 24: optische Welle
- 25: Mikroküvette
- 26: Wellenleiterbereich
- 27: kontinuierlicher Bereich
- 28: Graben
- 29: Graben
- 30: Wellenleiter
- 31: dicker Bereich
- 32: Übergangsbereich
- 33: dünner Bereich
- 34: erste Richtung
- 40: Maske
- 41: breiter absorberfreier Bereich
- 42: Verjüngungsbereich
- 43: schmaler absorberfreier Bereich
- 44: zweite Richtung
- 45: Stirnfläche

## Patentansprüche

1. Verfahren zur Herstellung eines Formteils mit mindestens einer Fasertaper-Aufnahme (5b,13,18), wobei ein Mikrostrukturkörper hergestellt wird, durch galvanische Abformung des Mikrostrukturkörpers ein Formwerkzeug (7) hergestellt wird und mittels Abformung des Formwerkzeugs (7) das polymere Formteil (8) hergestellt wird, **dadurch gekennzeichnet,**
**daß** zur Herstellung des Mikrostrukturkörpers ein Substrat (1) mit einem strahlungsempfindlichen Material (4) derart beschichtet wird, daß die Schichtdicke des strahlungsempfindlichen Materials (4) in einer ersten Richtung (34) über mindestens einen Übergangsbereich (32) des Substrats (1) kontinuierlich abnimmt ,
**daß** in das beschichtete Substrat (1) durch einen Belichtungsprozeß eine im Querschnitt im wesentlichen rechteckige grabenförmige Struktur (5a) eingebracht wird, welche sich in einer zweiten Richtung (44) über mindestens einen Verjüngungsbereich kontinuierlich verjüngt,
und **daß** der Belichtungsprozeß so geführt wird, daß der Verjüngungsbereich und der Übergangsbereich (32) zur Deckung kommen.

2. Verfahren nach Anspruch 1, **dadurch gekennzeichnet, daß** das beschichtete Substrat (1) durch mindestens eine Maske (40) mit mindestens einem absorberfreien Bereich (41,42,43) hindurch belichtet wird, wobei der absorberfreie Bereich (41,42,43) sich in der zweiten Richtung (44) über mindestens einen Bereich kontinuierlich verjüngt und die Maske (40) zum beschichteten Substrat derart ausgerichtet wird, daß die erste und die zweite Richtung (34,44) parallel oder anti-parallel liegen.

3. Verfahren nach einem der vorhergehenden Ansprüche **dadurch gekennzeichnet, daß** die Beschichtung derart durchgeführt wird, daß der Übergangsbereich (32) des strahlungsempfindlichen Materials (4) stufenlos in einen zweiten Bereich (33) mit konstanter Höhe übergeht.

4. Verfahren nach einem der vorgehenden Ansprüche **dadurch gekennzeichnet, daß** eine Maske (40) verwendet wird, deren Verjüngungsbereich (42) stufenlos in einen zweiten, für den Wellenleiter vorgesehenen absorberfreien Bereich konstanter Breite (43) übergeht.

5. Verfahren nach einem der vorhergehenden Ansprüche **dadurch gekennzeichnet, daß** zur Herstellung des Mikrostrukturkörpers ein profiliertes Substrat (1) verwendet wird, wobei das Höhenprofil des Substrats (1) in der ersten Richtung mindestens über einen Bereich im wesentlichen kontinuierlich zunimmt.

6. Verfahren nach einem der vorhergehenden Ansprüche, **dadurch gekennzeichnet, daß** die Beschichtung des Substrats (1) so erfolgt, daß die Oberfläche des strahlungsempfindlichen Materials (4) eben ist.

7. Verfahren nach einem der vorhergehenden Ansprüche, dadurch gekennzeichnt, daß das Substrat (1) mit einem röntgenempfindlichen Resist (4) oder mit einem Photolack beschichtet wird und zur Belichtung Synchrotronstrahlung oder UV-Strahlung verwendet wird.

8. Verfahren nach einem der vorhergehenden Ansprüche, **dadurch gekennzeichnet, daß** in die Fasertaper-Aufnahme (5b, 13, 18) des Formteils (8) des optischen Bauelements ein Fasertaper und ein Kernmaterial eingebracht wird, welches sich nach Einbringen des Fasertapers (9) verfestigt.

9. Verfahren nach einem der vorhergehenden Ansprüche, **dadurch gekennzeichnet, daß** am verjüngten Ende der Fasertaper-Aufnahme (5b,13,18) eine Stirnfläche (45) geschaffen wird.

10. Verfahren nach einem der Ansprüche 5 oder 6, **dadurch gekennzeichnet, daß** das profilierte Substrat (1) durch Drahterosion und/oder Ultrapräzisions-Frästechnik und/oder Excimerlaserbearbeitung und/oder UV-Grauton-Belichtung hergestellt wird.

11. Verfahren nach einem der Ansprüche 5 oder 6, **dadurch gekennzeichnet, daß** das profilierte Substrat (1) mittels Röntgentiefenlithographie und anschließender galvanischer Abformung hergestellt wird, wobei die Richtung des Röntgenstrahls parallel zur profilierten Oberfläche des Substrats liegt.

12. Bauelement, das ein Formteil (8) aufweist, welches mindestens eine Fasertaper-Aufnahme (5b,13,18) in Form eines Grabens (28) besitzt, der an das Verjüngungsprofil eines aufzunehmenden Fasertapers (9,14,16,17,20) angepaßt ist, wobei Grabentiefe und Grabenbreite über mindestens einen Bereich (27) kontinuierlich zur Fasertaperspitze hin abnehmen, sowie eine Deckplatte (10, 25) aufweist
**dadurch gekennzeichnet,**
**daß** der Graben (28) einen im wesentlichen rechteckigem Querschnitt aufweist, und
**daß** die Oberseite des Formteils (8) derart an den Verlauf der Grabentiefe angepaßt ist, daß der Graben (28) den gesamten aufzunehmenden Fasertaper (9,14,16,17,20) aufnimmt, und
**daß** die Deckplatte (10, 25) keinen für den aufzunehmenden Fasertaper (9,14,16,17,20) vorgesehenen Graben aufweist.

13. Bauelement nach Anspruch 12, **dadurch gekennzeichnet, daß** Höhe und Breite der Fasertaper-Aufnahme (5b, 13, 18) größer sind als die Summe aus Mittelwert und zugehöriger Standardabweichung bezüglich des Durchmessers des aufzunehmenden Fasertapers (9,14,16,17,20).

14. Bauelement nach einem der Ansprüche 12 oder 13, **dadurch gekennzeichnet, daß** sich an den verjüngenden Bereich (27) der Fasertaper-Aufnahme (5b, 13, 18) ein zweiter Graben (29) für einen Wellenleiter (30) anschließt, dessen Breite und Höhe über einen Bereich im wesentlichen konstant sind.

15. Bauelement nach einem der Ansprüche 12 bis 14, **dadurch gekennzeichnet, daß** die Oberseite des Formteils (8) eben ist.

16. Bauelement nach einem der Ansprüche 12 bis 15, **dadurch gekennzeichnet, daß** der Graben (27, 28, 29) der Fasertaper-Aufnahme (5b, 13, 18) allseitig in Umfangsrichtung der Achse des aufzunehmenden Fasertapers (9,14,16,17,20) umschlossen ist.

17. Bauelement nach einem der Ansprüche 12 bis 15, **dadurch gekennzeichnet, daß** die Oberseite des Formteils (8) im Bereich der Fasertaper-Aufnahme (5b, 13, 18) offen ist.

18. Bauelement nach einem der Ansprüche 12 bis 17, **dadurch gekennzeichnet, daß** in den Graben (28) der Fasertaper-Aufnahme (5b, 13, 18) ein Material eingebracht ist, welches Freiräume zwischen der Fasertaper-Aufnahme (5b,13,18) und dem aufzunehmenden Fasertaper (9,14,16,17,20) ausfüllt.

19. Bauelement nach einem der Ansprüche 12 bis 18, **dadurch gekennzeichnet, daß** die Fasertaper-Aufnahme (5b, 13, 18) auf der der Fasertaperspitze zugeordneten Seite länger als der aufzunehmende Fasertaper (9,14,16,17, 20) ist.

20. Bauelement nach Anspruch 19, **dadurch gekennzeichnet, daß** Höhe und/oder Breite der Fasertaper-Aufnahme (5b, 13, 18) am der Taperspitze zugeordneten Ende der Aufnahme kleiner als der kleinste Durchmesser des aufzunehmenden Fasertapers (9,14,16,17,20) ist.

21. Bauelement nach einem der Ansprüche 12 bis 20, **dadurch gekennzeichnet, daß** die Fasertaper-Aufnahme (5b, 13, 18) am sich verjüngenden Ende eine Stirnfläche aufweist, die im wesentlichen senkrecht zur Achse des aufzunehmenden Fasertapers (9,14,16,17,20) liegt.

## Claims

1. A method for manufacturing a moulded part with at least one fiber taper receptacle (5b, 13, 18), wherein a microstructure element is produced, wherein a moulding tool (7) is produced by galvanically casting the microstructure element, and wherein the polymer moulded part (8) is produced by means of the moulding tool (7), **characterized**
**by** the fact that the microstructure element is manufactured by coating a substrate (1) with a radiation-sensitive material (4) in such a way that the layer thickness of the radiation-sensitive material (4) continuously decreases in a first direction (34) over at least a transition region (32) of the substrate (1),
by the fact that a pit-shaped structure (5a) of essentially rectangular cross section which is continuously tapered in a second direction (44) over at least a tapered region is produced in the coated substrate (1) by means of an exposure process,
and by the fact that the exposure process is carried out in such a way that the tapered region and the transition region (32) are aligned with one another.

2. The method according to Claim 1, **characterized by** the fact that the coated substrate (1) is exposed through at least one mask (40) with at least one absorber-free region (41, 42, 43), wherein the absorber-free region (41, 42, 43) is continuously tapered in the second direction (44) over at least one region, and wherein the mask (40) is aligned relative to the coated substrate in such a way that the first and the second direction (34, 44) lie parallel or anti-parallel to one another.

3. The method according to one of the preceding claims, **characterized by** the fact that the coating process is carried out in such a way that the transition region (32) of the radiation-sensitive material (4) smoothly transforms into a second region (33) of constant height.

4. The method according to one of the preceding claims, **characterized by** the fact that a mask (40) is used in which the tapered region (42) smoothly transforms into a second absorber-free region of constant width (43) which is intended for the waveguide.

5. The method according to one of the preceding claims, **characterized by** the fact that a profiled substrate (1) is used for manufacturing the microstructure element, wherein the height profile of the substrate (1) essentially increases continuously in the first direction over at least one region.

6. The method according to one of the preceding claims, **characterized by** the fact that the coating of the substrate (1) is carried out in such a way that the surface of the radiation-sensitive material (4) is plane.

7. The method according to one of the preceding claims, **characterized by** the fact that the substrate (1) is coated with a resist (4) that is sensitive to X-rays or with a photoresist, and by the fact that synchrotron radiation or UV-radiation is used for the exposure process.

8. The method according to one of the preceding claims, **characterized by** the fact that a fiber taper and a core material are introduced into the fiber taper receptacle (5b, 13, 18) of the moulded part (8) of the optical component, wherein the core material solidifies after introducing the fiber taper (9).

9. The method according to one of the preceding claims, **characterized by** the fact that an end face (45) is produced on the tapered end of the fiber taper receptacle (5b, 13, 18).

10. The method according to Claim 5 or 6, **characterized by** the fact that the profiled substrate (1) is produced by means of wire-EDM and/or ultra-precision milling and/or excimer laser processing and/or UV-gray tint exposure.

11. The method according to Claim 5 or 6, **characterized by** the fact that the profiled substrate (1) is produced by means of X-ray lithography and subsequent galvanic casting, wherein the direction of the X-ray extends parallel to the profiled surface of the substrate.

12. A component comprising a moulded part (8) that contains at least one fiber taper receptacle (5b, 13, 18) in the form of a pit (28) that is adapted to the tapered profile of a fiber taper (9, 14, 16, 17, 20) to be accommodated, wherein the depth and the width of the pit continuously decrease toward the tip of the fiber taper over at least one region (27), and wherein the component also contains a cover plate (10, 25),
**characterized by** the fact
that the pit (28) has an essentially rectangular cross section, by the fact
that the upper side of the moulded part (8) is adapted to the progression of the pit depth in such a way that the pit (28) accommodates the entire fiber taper (9, 14, 16, 17, 20) to be accommodated, and by the fact
that the cover plate (10, 25) is not provided with a designated pit for the fiber taper (9, 14, 16, 17, 20) to be accommodated.

13. The component according to Claim 12, **characterized by** the fact that the height and the width of the fiber taper receptacle (5b, 13, 18) are greater than the sum of the average value and the corresponding standard deviation referred to the diameter of the fiber taper (9, 14, 16, 17, 20) to be accommodated.

14. The component according to Claim 12 or 13, **characterized by** the fact that a second pit (29) for a waveguide (30) is situated adjacent to the tapered region (27) of the fiber taper receptacle (5b, 13, 18), wherein the width and the height of this second pit are essentially constant over one region.

15. The component according to one of Claims 12-14, **characterized by** the fact that the upper side of the moulded part (8) is plane.

16. The component according to one of Claims 12-15, **characterized by** the fact that the pit (27, 28, 29) of the fiber taper receptacle (5b, 13, 18) is enclosed on all sides in the circumferential direction of the axis of the fiber taper (9, 14, 16, 17, 20) to be accommodated.

17. The component according to one of Claims 12-15, **characterized by** the fact that the upper side of the moulded part (8) is open in the region of the fiber taper receptacle (5b, 13, 18).

18. The component according to one of Claims 12-17, **characterized by** the fact that a material which fills out the free spaces between the fiber taper receptacle (5b, 13, 18) and the fiber taper (9, 14, 16, 17, 20) to be accommodated is introduced into the pit (28) of the fiber taper receptacle (5b, 13, 18).

19. The component according to one of Claims 12-18, **characterized by** the fact that the fiber taper receptacle (5b, 13, 18) is longer than the fiber taper (9, 14, 16, 17, 20) to be accommodated on the side that is assigned to the tip of the fiber taper.

20. The component according to Claim 19, **characterized by** the fact that the height and/or width of the fiber taper receptacle (5b, 13, 18) is/are smaller than the smallest diameter of the fiber taper (9, 14, 16, 17, 20) to be accommodated on the end that is assigned to the tip of the taper.

21. The component according to one of Claims 12-20, **characterized by** the fact that the fiber taper receptacle (5b, 13, 18) contains an end face on the tapered end which essentially lies perpendicular to the axis of the fiber taper (9, 14, 16, 17, 20) to be accommodated.

## Revendications

1. Procédé pour la fabrication d'une pièce moulée avec au moins un récepteur de fuseau de fibres (5b, 13, 18), un corps à microstructure étant fabriqué, un outillage de moulage (7) étant fabriqué par moulage galvanique du corps à microstructure et la pièce moulée en polymère (8) étant fabriquée au moyen d'un moulage par l'outillage de moulage (7), **caractérisé en ce que**,
pour la fabrication du corps à microstructure, un substrat (1) est revêtu d'une matière sensible aux rayonnements (4) de manière à ce que l'épaisseur de couche de la matière sensible aux rayonnements (4) diminue en continu dans une première direction (34) sur au moins une zone de transition (32) du substrat (1),
que, dans le substrat revêtu (1) est intégrée par processus d'exposition une structure en forme de rigole essentiellement rectangulaire (5a) en section transversale, qui se rétrécit en continu dans une deuxième direction (44) sur au moins une zone de rétrécissement
et que le processus d'exposition est réalisé de manière à ce que la zone de rétrécissement et la zone de transition (32) viennent à se recouvrir.

2. Procédé selon la revendication 1, **caractérisé en ce que** le substrat revêtu (1) est exposé à travers au moins un cache (40) comportant au moins une zone non absorbante (41, 42, 43), la zone non absorbante (41, 42, 43) se rétrécissant en continu dans la deuxième direction (44) sur au moins une zone et le cache (40) destiné au substrat revêtu étant aligné de telle manière que la première et la deuxième direction (34, 44) soient parallèles ou anti-parallèles.

3. Procédé selon une des revendications précédentes, **caractérisé en ce que** le revêtement est réalisé de manière à ce que la zone de transition (32) de la matière sensible aux rayonnements (4) transite sans paliers dans une deuxième zone (33) à hauteur constante.

4. Procédé selon une des revendications précédentes, **caractérisé en ce qu'**est utilisé un cache (40), dont la zone de rétrécissement (42) transite sans paliers dans une deuxième zone non absorbante de largeur constante (43) prévue pour le guide d'ondes.

5. Procédé selon une des revendications précédentes, **caractérisé en ce qu'**est utilisé, pour la fabrication du corps à microstructure, un substrat profilé (1), le profil de hauteur du substrat (1) augmentant globalement en continu dans une première direction au moins sur une zone.

6. Procédé selon une des revendications précédentes, **caractérisé en ce que** le revêtement du substrat (1) est réalisé de manière à ce que la surface de la matière sensible aux rayonnements (4) soit plane.

7. Procédé selon une des revendications précédentes, **caractérisé en ce que** le substrat (1) est recouvert d'une résistance sensible aux rayons X (4) ou d'une matière photorésistante et qu'un rayonnement à synchrotrons ou UV est utilisé pour l'exposition.

8. Procédé selon une des revendications précédentes, **caractérisé en ce que**, dans le récepteur de fuseau de fibres (5b, 13, 18) de la pièce moulée (8) du composant optique, est intégré un fuseau de fibres et une matière de noyau qui se consolide après l'introduction du fuseau de fibres (9).

9. Procédé selon une des revendications précédentes, **caractérisé en ce qu'**à l'extrémité rétrécie du récepteur de fuseau de fibres (5b, 13, 18), une surface frontale (45) est créée.

10. Procédé selon une des revendications 5 ou 6, **caractérisé en ce que** le substrat profilé (1) est fabriqué par érosion par fil et/ou technique de fraisage à ultra-précision et/ou usinage au laser excimère et/ou exposition en tons gris aux UV.

11. Procédé selon une des revendications 5 ou 6, **caractérisé en ce que** le substrat profilé (1) est fabriqué au moyen d'une lithographie en profondeur aux rayons X suivie d'un moulage galvanique, la direction du rayon X étant parallèle à la surface profilée du substrat.

12. Composant qui présente une pièce moulée (8), celle-ci possédant au moins un récepteur de fuseau de fibres (5b, 13, 18) sous la forme d'une rigole (28) qui est adaptée au profil de rétrécissement d'un fuseau de fibres à recevoir (9, 14, 16, 17, 20), la profondeur et la largeur de la rigole diminuant en continu en direction de la pointe du fuseau de fibres sur au moins une zone (27), et qui présente également une plaque de recouvrement (10, 25)
**caractérisé en ce que**
la rigole (28) présente une section transversale essentiellement rectangulaire, et
que la face supérieure de la pièce moulée (8) est adaptée au tracé de la profondeur de rigole de telle sorte que la rigole (28) réceptionne tout le fuseau de fibres (9, 14, 16, 17, 20) à recevoir et
que la plaque de recouvrement (10, 25) ne présente pas de rigole prévue pour le fuseau de fibres à recevoir (9, 14, 16, 17, 20).

13. Composant selon la revendication 12, **caractérisé en ce que** la hauteur et la largeur du récepteur de fuseau de fibres (5b, 13, 18) sont supérieures à la somme de la valeur moyenne et de l'écart standard afférent par rapport au diamètre du fuseau de fibres à recevoir (9, 14, 16, 17, 20).

14. Composant selon une des revendications 12 ou 13, **caractérisé en ce que** se raccorde à la zone allant en se rétrécissant (27) du récepteur de fuseau de fibres (5b, 13, 18) une deuxième rigole (29) pour un guide d'ondes (30), dont la largeur et la hauteur sont globalement constantes sur une zone.

15. Composant selon une des revendications 12 à 14, **caractérisé en ce que** la face supérieure de la pièce moulée (8) est plane.

16. Composant selon une des revendications 12 à 15, **caractérisé en ce que** la rigole (27, 28, 29) du récepteur de fuseau de fibres (5b, 13, 18) est cernée de tous côtés dans le sens du volume de l'axe du fuseau de fibres à recevoir (9, 14, 16, 17, 20).

17. Composant selon une des revendications 12 à 15, **caractérisé en ce que** la face supérieure de la pièce moulée (8) est ouverte dans 1a zone du récepteur de fuseau de fibres (5b, 13, 18).

18. Composant selon une des revendications 12 à 17, **caractérisé en ce que**, dans la rigole (28) du récepteur de fuseau de fibres (5b, 13, 18), est intégrée une matière qui remplit les espaces libres entre le récepteur de fuseau de fibres (5b, 13, 18) et le fuseau de fibres à recevoir (9, 14, 16, 17, 20).

19. Composant selon une des revendications 12 à 18, **caractérisé en ce que** le récepteur de fuseau de fibres (5b, 13, 18) est sur son côté associé à la pointe du fuseau de fibres plus long que le fuseau de fibres à recevoir (9, 14, 16, 17, 20).

20. Composant selon la revendication 19, **caractérisé en ce que** la hauteur et/ou la largeur du récepteur de fuseau de fibres (5b, 13, 18) est, à l'extrémité du récepteur associée à la pointe du fuseau, inférieure au diamètre le plus petit du fuseau de fibres à recevoir (9, 14, 16, 17, 20).

21. Composant selon une des revendications 12 à 20, **caractérisé en ce que** le récepteur de fuseau de fibres (5b, 13, 18) présente à son extrémité allant en se rétrécissant une surface frontale qui est globalement perpendiculaire à l'axe du fuseau de fibres à recevoir (9, 14, 16, 17, 20).
